# EUROPÄISCHE PATENTSCHRIFT

(11) **EP 0 374 483 B1**
(45) Veröffentlichungstag und Bekanntmachung des Hinweises auf die Patenterteilung: **26.05.1993**
(21) Anmeldenummer: 89121279.7
(22) Anmeldetag: 17.11.1989
(51) Int. Cl.: H05K 3/40, H05K 3/10

(54) **Verfahren zur Herstellung von mit Kontaktflächen versehenen Gedruckten Schaltungen**
Process for the production of printed circuits with contact areas
Procédé de production de circuits imprimés présentant des surfaces de contact

(30) Priorität: 23.12.1988 DE 3843528
(43) Veröffentlichungstag der Anmeldung: 27.06.1990
(73) Patentinhaber: Schoeller & Co. Elektronik GmbH, D-35083 Wetter (DE); Degussa Aktiengesellschaft, 60311 Frankfurt (DE)
(72) Erfinder: Ritz, Klaus, Dr., D-3552 Wetter/Hessen (DE)
(74) Vertreter: Weber, Wolfgang

(56) Entgegenhaltungen:
- DE-A- 3 235 212
- DE-B- 1 182 319

## Beschreibung

Die Erfindung betrifft ein Verfahren zur Herstellung von mit Kontaktflächen versehenen Gedruckten Schaltungen, die diese Kontaktflächen auf der Oberfläche oder im Innern in Form erhabener Flächen auf Kupferfolien oder Leiterbahnen aufweisen.

Nahezu alle elektronischen Geräte werden heute auf Basis von Gedruckten Schaltungen aufgebaut. Bei größeren Systemen ist es aus technischen und wirtschaftlichen Gründen notwendig, mehrere Gedruckten Schaltungen miteinander zu verbinden, wobei elektrische Verbindungen zwischen den einzelnen Leiterplatte geknüpft werden müssen. Hierzu dienen beispielsweise Verbindungsdrähte oder Kabel, die an vorbereiteten Stellen in die Gedruckten Schaltungen eingelötet werden, Steckverbinder, die aufgesteckt werden, oder Anpressverbinder, bei denen besonders vorbereitete Teile der Gedruckten Schaltungen in direkten Kontakt zueinander gebracht und durch geeignete mechanische Elemente federnd aufeinandergepresst werden.

Die Leiterbahnen der einzelnen Gedruckten Schaltungen enden normalerweise in Kontaktflächen, die in konkruenten Mustern angeordnet sind und aufeinandergepresst werden müssen. Eine solche Anpreßverbindung ist beispielsweise in der DE-A-32 35 212 beschrieben. Die Kontaktflächen sind meist erhaben ausgebildet und überragen die Isolierschicht, die die Leiterbahnen umgibt.

Die Kontaktflächen können dabei galvanisch verstärkt oder mit Lotlegierungen versehen werden.

Das galvanische oder mechanische Aufbringen von Metallen oder Legierungen auf die Kontaktflächen ist allerdings zeitaufwendig und daher teuer. Außerdem entstehen relativ rauhe, unebene Flächen, die keine optimale Kontaktierung ergeben.

Bei den sogenannten Sacklochmultilayern sind neben durchgehenden, metallisierten Bohrungen zur Verbindung der verschiedenen Leiterebenen auch metallisierte Bohrungen vorhanden, die auf einem Lötauge der ersten (oder zweiten) Innenlage enden und dadurch Raum für die Leiterführung auf den übrigen Innenlagen lassen. Die Sacklochbohrungen müssen durch präzises Niveaubohren mit Tiefentoleranzen von ca. + 50 µm hergestellt werden. Wegen der geringen erlaubten Tiefentoleranz ist dies in einer Serienfertigung sehr schwierig.

In der DE-B-1 182 319 sind Verfahren zur Erzeugung eines Leitungsmusters auf einer Isolierstoffgrundplatte beschrieben. Ein Verfahren besteht darin, daß die Grundplatte mit Löchern versehen wird, daß dann auf die Grundplatte eine Metallfolie aufgelegt wird, daß dann die Metallfolie mit einem nachgiebigen Druckkissen gegen eine Widerlagerplatte in die Löcher gedrückt wird, daß dann die Metallfolie bis auf das stehenbleibende Leitungsmuster fortgeätzt wird und daß dann das Leitungsmuster mit einer Isolierstoffschicht bedeckt wird.

Es war daher Aufgabe der vorliegenden Erfindung, ein Verfahren zur Herstellung von mit Kontaktflächen versehenen Gedruckten Schaltungen zu entwickeln, die diese Kontaktflächen auf der Oberläche oder im Innern in Form erhabener Flächen auf Kupferfolien oder Leiterbahnen aufweisen, wobei diese Kontaktflächen einfach herstellbar und mit möglichst glatten Oberflächen versehen sein sollten.

Diese Aufgabe wird erfindungsgemäß dadurch gelöst, daß Kupferfolien gegen eine mit erhabenen Flächen in einem vorgegebenen Muster versehene Schablone gepresst werden,
daß das Innere der in den Kupferfolien entstandenen Prägeabdrücke mit einem aushärtenden Material ausgefüllt wird,
daß die so ausgefüllten Kupferfolien mit Prepregs zu kupferbeschichteten Vorlaminaten verpresst werden, und daß diese Vorlaminate mit anderen Vorlaminaten zu Gedruckten Schaltungen weiterverarbeitet werden, wobei die Kupferfolien aus hochduktilem Kupfer mit einer Bruchdehnung > 10% bestehen und eine Dicke von 10 bis 100 µm aufweisen müssen.

Vorzugsweise werden die erhabenen Flächen als Kugelkalotten ausgebildet, doch können auch andersartig gestaltete Prägeabdrücke hergestellt werden. Insbesondere besitzen die Kugelkalotten an der Basis einen Durchmesser von 50 bis 1000 µm und eine Höhe von 30 bis 200 µm.

Die geprägten Kupferfolien lassen sich besonders einfach verarbeiten, wenn man als aushärtendes Material zum Ausfüllen der Prägeabdrücke das Harz der Prepregs verwendet, wobei es von Vorteil sein kann, diesem Harz noch wenig kompressible Teilchen, beispielsweise in Form von Metall- oder Keramikpulver beizufügen.

Mit Kontaktflächen versehene Gedruckten Schaltungen lassen sich erfindungsgemäß dadurch herstellen, daß man 10 bis 100 um dicke Kupferfolien aus RA-Kupfer (mit einer Bruchdehnung größer 10 %) gegen eine Schablone presst, welche an vorbestimmten Stellen, die dem gewünschten Kontaktmuster entsprechen, erhöhte Flächen aufweist.

Wegen der hohen Duktilität der Kupferfolien überträgt sich das Bild der Schablone sehr maßgenau auf die Kupferfolie, ohne daß diese reißt. Anschließend werden beispielsweise ein oder mehrere Prepregs auf die Rückseite der Kupferfolien auflaminiert, wobei das Harz der Prepregs das Innere der geprägten Kontaktflächen ausfüllt und damit stabilisiert. Diese Vorlaminat lässt sich zu zweiseitigem Basismaterial oder als Außenlage von Multilagern weiterverarbeiten. Die so hergestellten Schaltungen weisen an vorbestimmten Stellen erhabene Kontaktflächen auf.

Anstatt mit dem Harz der Prepregs können die Kontaktflächen auch mit niedrigschmelzenden Metallegierungen ausgefüllt werden.

Folgende Beispiele sollen das erfindungsgemäße Verfahren näher erläutern:

### 1. Herstellung einer zweilagigen starren Schaltung mit erhabenen Kontaktpunkten

Eine 35 µm dicke Folie aus RA-Kupfer wird auf eine Schablone gelegt, die ein erhabenes Muster von Kontaktpunkten aufweist. Das Kontaktpunktmuster besteht aus zwei Reihen von Punkten, wobei der Abstand zwischen 2 Punkten einer Reihe 1,27 mm (1/20") beträgt. Jeder erhabene Kontaktpunkt der Schablone ist 150 µm hoch, hat die Form eines an der Spitze verrundeten Kegels und ist an der Basis ca. 0,9 mm breit. Unter Verwendung einer "weichen" Paketierung wird die RA-Kupferfolie bei Drucken zwischen 2 und 4 MPa etwa 3 min. gegen die Schablone gepreßt. Die hohe Duktilität der Kupferfolie verhindert das Reißen während der Verformung. Nach der Verformung wird die Kupferfolie von der Schablone abgenommen und auf eine zweite, ca. 250 µm dicke Schablone gelegt, die an der Stelle der Kontaktpunkte Freibohrungen mit Durchmesser gleich dem Basisdurchmesser der Kontaktpunkte der verformten Kupferfolie enthält. Die erhabenen Kontaktpunkte der verformten Kupferfolie tauchen vollständig in diese Schablone ein. Auf die Innenseite (Treatmentseite) der verformten Kupferfolie legt man 2 Prepregs sowie ein einseitig kupferkaschiertes Basismaterial der Dicke 1 - 1,4 mm, wobei die Kupferseite oben liegt. Dieser Aufbau wird bei 170 - 180^{o} und einem Druck zwischen 2 und 4 MPa verpreßt. Da sich das Harz des Prepregs beim Aufheizen der Presse verflüssigt, füllt es vollständig die erhabenen Druckpunkte der verformten Kupferfolie von der Innenseite her aus. Das Ergebnis ist ein beidseitig kupferkaschiertes Laminat, das auf einer Seite erhabene 150 µm hohe, ca. 0,9 mm breite Erhöhungen aufweist.

Das Laminat wird mit bekannten Methoden zu einer zweilagigen, durchkontaktierten Leiterplatte mit Blei-Zinn Oberfläche verarbeitet, die auf einer Seite 2 Reihen von Kontaktpunkten im Raster 1,27 mm enthält, wobei zwischen 2 Kontaktpunkten jeweils eine Leiterbahn ca. 80 - 100 µm breit verläuft. Preßt man unter Verwendung handelsüblicher Stecker eine flexible Schaltung (1- oder 2-lagig) mit entsprechendem Anschlußmuster und PbSn Oberfläche auf die erhöhten Kontaktpunkte, ergibt sich eine gasdichte, lösbare Verbindung.

### 2. Herstellung einer Innenlage für Sacklochmultilayer

Ersetzt man bei Beispiel 1 das einseitig kupferkaschierte starre Basismaterial durch eine Trennfolie, erhält man ein dünnes (ca. 180 µm), einseitig kupferkaschiertes Laminat mit erhabenen Stellen, das als erste Innenlage in einem Sacklochmultilayer verwendet werden kann. Dabei werden durch konventionelles Verfahren die erhabenen Stellen als "deformierte" Lötaugen in Leiterbahnanschlüssen ausgebildet. Da in einem solchen Multilayer das anzubohrende Lötauge sehr dicht unter der Oberfläche liegt, verringert sich die Gefahr einer ungewollten Kotaktierung der zweiten Innenlage, d.h. die Tiefentoleranz der Sacklochbohrung erweitert sich um ca. 150 µm.

### 3. Flexible Schaltungen mit erhöhten Kontaktpunkten.

Laminiert man eine "deformierte" RA-Kupferfolie gemäß Beispiel 1 unter Verwendung zweier Klebefolien (z.B. je 50 um dick) auf eine Deckfolie (z.B. Polyimid), so erhält man ein flexibles Laminat mit erhöhten Stellen. Auch hier füllen die Klebefolien beim Laminieren (2 - 4 MPa, T = 170 - 180^{o} C) die erhabenen Stellen von der Rückseite her aus.

Statt die erhabenen Stellen als Kalotten- oder kegelförmige Kontaktstellen auszubilden, kann man sie auch als Lotflächen für oberflächenmontierbare Bauelemente ausbilden. Bei derart hergestellten Schaltungen liegen die Bauelemente ca. 0,2 mm über der Oberfläche, so daß infolge des größeren Spaltes die Reinigung nach dem Auflöten der Bauelemente wesentlich vereinfacht wird.

## Patentansprüche

1. Verfahren zur Herstellung von mit Kontaktflächen versehenen Gedruckten Schaltungen, die diese Kontaktflächen auf der Oberfläche oder im Innern in Form erhabener Flächen auf Kupferfolien oder Leiterbahnen aufweisen,
dadurch gekennzeichnet,
daß Kupferfolien gegen eine mit erhabenen Flächen in einem vorgegebenen Muster versehene Schablone gepresst werden,
daß das Innere der in den Kupferfolien entstandenen Prägeabdrücke mit einem aushärtenden Material ausgefüllt wird,
daß die so ausgefüllten Kupferfolien mit Prepregs zu kupferbeschichteten Vorlaminaten verpresst werden,
und daß diese Vorlaminate mit anderen Vorlaminaten zu Gedruckten Schaltungen weiterverarbeitet werden, wobei die Kupferfolien aus hochduktilem Kupfer mit einer Bruchdehnung größer 10 % bestehen und eine Dicke von 10 bis 100 µm aufweisen müssen.

2. Verfahren nach Anspruch 1,
dadurch gekennzeichnet,
daß die erhabenen Flächen als Kugelkalotten ausgebildet werden.

3. Verfahren nach Anspruch 1 und 2,
dadurch gekennzeichnet,
daß die Kugellotten an der Basis einen Durchmesser von 50 bis 1000 µm und eine Höhe von 30 bis 200 µm aufweisen.

4. Verfahren nach Anspruch 1, 2 oder 3,
dadurch gekennzeichnet,
daß als aushärtendes Material das Harz der Prepregs verwendet wird.

## Claims

1. A process for the production of printed circuits provided with contact surfaces which comprise these contact surfaces on the surface or in the interior in the form of raised surfaces on copper foils or printed conductors, characterized in that copper foils are pressed against a template provided with raised surfaces in a predetermined pattern, in that the interior of the embossed impressions formed in the copper foils are filled with a curing material, in that the copper foils thus filled are pressed with prepregs to form copper-covered prelaminates and in that these prelaminates are further processed with other prelaminates to form printed circuits, the copper foils consisting of high-ductility copper with a breaking elongation of greater than 10% and having to have a thickness of 10 to 100 µm.

2. A process as claimed in claim 1, characterized in that the raised surfaces are hemispherical in shape.

3. A process as claimed in claims 1 and 2, characterized in that the hemispheres have a base diameter of 50 to 1000 µm and a height of 30 to 200 µm.

4. A process as claimed in claim 1, 2 or 3, characterized in that the resin of the prepregs is used as the curing material.

## Revendications

1. Procédé de fabrication de circuits imprimés munis de surfaces de contact, qui présentent ces surfaces de contact sur des feuilles de cuivre ou pistes conductives à la surface ou à l'intérieur sous forme de surfaces en relief, caractérisé :
- en ce que les feuilles de cuivre sont pressées contre un gabarit muni de surfaces en relief dans un modèle prédéterminé,
- en ce que l'intérieur des empreintes prenant naissance dans les feuilles de cuivre, est rempli d'un matériau durcissant,
- en ce que les feuilles de cuivre ainsi remplies sont comprimées avec des feuilles préimprégnées en prélaminés recouverts de cuivre, et
- en ce que ces prélaminés sont transformés ultérieurement avec d'autres prélaminés en circuits imprimés, les feuilles de cuivre devant être constituées de cuivre fortement ductile avec un allongement à la rupture supérieur à 10 % et avoir une épaisseur de 10 à 100 10⁻⁶ m.

2. Procédé selon la revendication 1, caractérisé en ce que les surfaces en relief sont réalisées en calottes sphériques.

3. Procédé selon la revendication 1 ou la revendication 2, caractérisé en ce que les calottes sphériques ont à la base un diamètre de 50 à 1 000 . 10⁻⁶ m et une hauteur de 30 à 200 . 10⁻⁶ m.

4. Procédé selon les revendications 1, 2 ou 3, caractérisé en ce que, comme matériau durcissant, on utilise la résine de feuilles préimprégnées.
